# EUROPÄISCHE PATENTSCHRIFT

(11) **EP 3 991 297 B1**
(45) Veröffentlichungstag und Bekanntmachung des Hinweises auf die Patenterteilung: **07.10.2026**
(21) Anmeldenummer: 20742224.7
(22) Anmeldetag: 15.07.2020
(51) Int. Cl.: H03K 17/955, H03K 17/96, G06Q 10/08, G06Q 10/087, B65G 1/137

(54) **BEHÄLTNIS FÜR EIN WARENWIRTSCHAFTSSYSTEM**
CONTAINER FOR A GOODS MANAGEMENT SYSTEM
CONTENANT POUR SYSTÈME DE GESTION DE MARCHANDISES

(30) Priorität: 30.07.2019 AT 506932019
(43) Veröffentlichungstag der Anmeldung: 04.05.2022
(73) Patentinhaber: Pregenzer, Lukas, 6414 Mieming (AT)
(72) Erfinder: Pregenzer, Lukas, 6414 Mieming (AT)
(74) Vertreter: Lorenz Seidler Gossel Part. mbB
(86) Internationale Anmeldenummer: PCT/EP2020/069939
(87) Internationale Veröffentlichungsnummer: WO 2021/018579

(56) Entgegenhaltungen:
- WO-A1-2010/026280
- WO-A1-2019/064244
- WO-A2-2007/024639
- US-A1- 2003 052 778
- US-A1- 2017 278 059

## Beschreibung

Die Erfindung betrifft ein Behältnis für ein Warenwirtschaftssystem, das eine kapazitive Sensoreinrichtung zur Erfassung des Vorhandenseins und/oder der Füllmenge von Waren im Behältnis aufweist.

Warenwirtschaftssysteme sind aus dem Stand der Technik bekannt. Sie umfassen regelmäßig mehrere Behältnisse zur Aufnahme von Waren und eine Lagerverwaltungseinheit für die interne Bestandsführung. Im Zusammenhang mit derartigen Systemen ist es auch aus beispielsweise der DE 10 2007 031 174 A1 und der DE 10 2013 222 263 A1 bekannt geworden, Sensoren zur Erfassung des Vorhandenseins und/oder der Füllmenge von Waren vorzusehen. Weiterer Stand der Technik wird durch die Dokumente WO 2007/024639 A2, WO 2010/026280 A1, US 2003/052778 A1, US 2017/278059 A1 und WO 2019/064244 A1 repräsentiert.

Aufgabe der Erfindung ist es, Behältnisse für gattungsgemäße Warenwirtschaftssysteme bereitzustellen, die kostengünstig hergestellt werden können und trotzdem eine geeignete Grundlage zur Erfassung des Vorhandenseins und/oder der Füllmenge von Waren zu bilden.

Vor diesem Hintergrund betrifft die Erfindung ein Behältnis für ein Warenwirtschaftssystem, das zur Aufnahme von Waren ausgebildet ist, wobei das Behältnis eine kapazitive Sensoreinrichtung zur Erfassung des Vorhandenseins und/oder der Füllmenge von Waren aufweist, die eine Leiterbahn umfasst, die an wenigstens einer Begrenzungswand des Behältnisses auf ein Substrat aufgedruckt ist. Die Leiterbahnen dienen als kapazitive Messflächen. So ist eine Bestandskontrolle der Waren innerhalb des Behältnisses anhand einfachster Mittel möglich.

Bei der betreffenden Begrenzungswand handelt es sich vorzugsweise um den Boden des Behältnisses. Dies ist vorteilhaft, da die Waren direkt auf dem Boden und mithin der Messfläche aufliegen.

Erfindungsgemäß umfasst die kapazitive Sensoreinrichtung zwei Leiterbahnen, die an der Begrenzungswand des Behältnisses auf das Substrat aufgedruckt sind, wobei eine der Leiterbahnen als Messelektrode und die andere der Leiterbahnen als Schirmelektrode (GND-Elektrode) dient.

Erfindungsgemäß handelt es sich bei dem Substrat um die Oberfläche der Begrenzungswand. Die Leiterbahn ist in dieser Ausführungsform also direkt auf die Begrenzungswand aufgedruckt.

Die Sensoreinheit kann ausgebildet sein, periodisch kapazitive Bestandsabfragen durchzuführen. Dies geschieht durch periodische Bestromung der Leiterbahnen. Die abgefragten Signale können periodisch an eine Lagerverwaltungseinheit des Warenwirtschaftssystems übermittelt werden.

Die Sensoreinheit kann ferner eine Kommunikationsschnittstelle zur Übermittlung des Sensorsignals an eine Lagerverwaltungseinheit des Warenwirtschaftssystems aufweisen. Weiterhin kann als Bestandteil der Sensoreinheit eine Auswerteeinheit zur Digitalisierung des Sensorsignals vorgesehen sein. Das Sensorsignal kann in dieser Ausführungsvariante in digitaler Form an eine Verwaltungseinheit des Warenwirtschaftssystems weitergegeben werden.

In einer Ausführungsform kann vorgesehen sein, dass die Sensoreinrichtung mehrere Paare an als Mess- und Schirmelektroden dienenden Leiterbahnen umfasst, um Vorhandensein und/oder der Füllmenge von Waren in mehreren Bereichen oder Kompartimenten des Behältnisses gesondert kapazitiv erfassen zu können. Beispielsweise kann das das Behältnis mehrere Kompartimente aufweisen, die durch vorzugsweise vertikale Trennwände im Behältnis definiert werden, und für die zumindest teilweise individuelle Leiterbahnen bzw. individuelle Paare an als Mess- und Schirmelektroden dienenden Leiterbahnen vorgesehen sind, um darin Vorhandensein und/oder der Füllmenge von Waren gesondert kapazitiv erfassen zu können.

Bei dem Behältnis handelt es sich erfindungsgemäß um einen Karton, eine Kunststoffbox oder ein Holzbehältnis. Die Papieroberfläche von Kartons eignet sich originär sehr gut für die Bedruckung mit beispielsweise elektrisch leitender Tinte.

In einer anderen Ausführungsform kann das Behältnis Teil eines Möbels darstellen. Beispielsweise kann das Behältnis auch durch eine Schublade oder ein Fach einer Werkzeugkiste, eines Lagermöbels oder eines Möbels einer mobilen Einheit gebildet werden, in die oder das Waren eingelagert sind.

In einer Ausführungsform umfasst das Behältnis zusätzlich zu der kapazitiven Sensoreinrichtung noch eine separate, eigenschaftsbestimmende Sensoreinrichtung, die geeignet ist, eine qualitative Eigenschaft einer vorhandenen Ware zu bestimmen. In dieser Variante wird es ermöglicht, zusätzlich zu dem Vorhandensein bzw. der Füllmenge, welche anhand der kapazitiven Sensoreinrichtung bestimmt wird, auch noch eine qualitative Eigenschaft der Waren zu bestimmen, sofern vorhanden, beispielsweise die Konzentration eines bestimmten Inhaltsstoffes oder dergleichen. Die eigenschaftsbestimmende Sensoreinrichtung kann beispielsweise ein IR-Spektrometer, ein RFID-Lesegerät, eine Kamera nebst Bildauswertungselektronik oder eine elektromagnetische Sensorik umfassen. Besonders bevorzugt ist ein IR-Spektrometer.

Die Erfindung betrifft weiterhin ein Warenwirtschaftssystem mit einem oder mehreren erfindungsgemäßen Behältnissen.

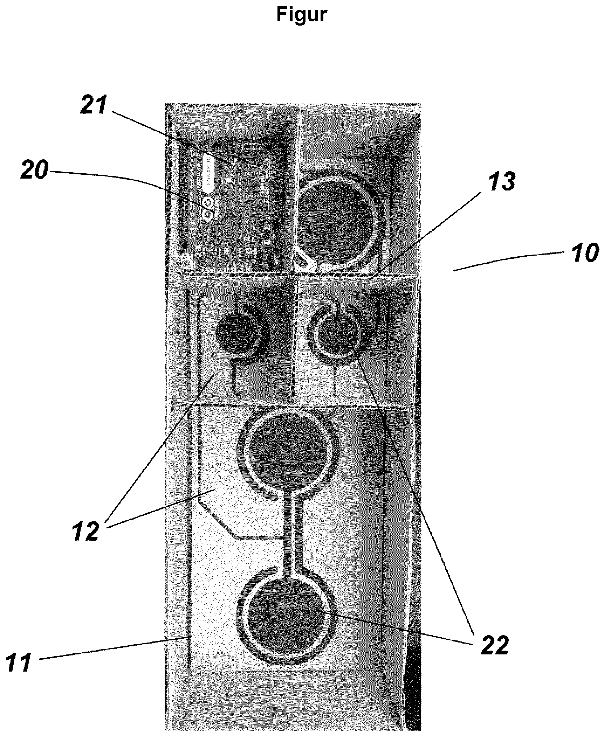

Weitere Einzelheiten und Vorteile der Erfindung ergeben sich aus dem nachfolgend anhand der Figur dargestellten Ausführungsbeispiel.

Die einzige Figur zeigt ein als Karton 10 ausgebildetes Behältnis gemäß einer Ausführungsform der Erfindung.

Kerngedanke der vorliegenden Erfindung ist die Verbesserung von Warenwirtschaftssystemen insoweit, als dem Anwender die Nachbeschaffung von Lagerware durch eine Automatisierung erleichtert wird. Dabei wird ein Behältnis in Form beispielsweise eines Kartons 10 bereitgestellt, welcher eine kapazitive Sensoreinrichtung 20 mit einer Elektronik 21 und auf den Boden 11 des Kartons 10 mit elektrisch leitender Tinte aufgedruckten Leiterbahnen 22 umfasst, konkret mehrere Paare an als Mess- und Schirmelektroden dienenden Leiterbahnen. Der Karton 10 umfasst mehrere Aufbewahrungsfächer 12, welche durch vertikale Wände 13 voneinander getrennt sind.

Die aufgedruckten Leiterbahnen 22 bilden kapazitive Messflächen zur Erfassung des Lagerbestands in den einzelnen Fächern 12 ab, welcher durch die Elektronik 21 in periodischen Abständen abgefragt wird. Detektiert die Elektronik 21 im Rahmen einer Abfrage, dass im Karton 10 bzw. konkret in einem Fach 12 gelagerte Ware entnommen wurden, so sendet sie automatische eine Bestellanforderung an eine in der Figur nicht dargestellte Lagerverwaltungseinheit des Warenwirtschaftssystems.

Es kann in diesem Zusammenhang vorgesehen sein, dass einem bestimmten Fach 12 gelagerte Waren dann, wenn sie mit einem Identifier ausgestattet sind, beispielsweise mit einem in der Medizintechnik üblichen UDI (Unique Device Identification; deutsch: Produktidentifizierungsnummer), vor einer Einlagerung durch Scannen des Codes, beispielsweise per App und Smartphone, identifiziert werden. Die Lagerverwaltungseinheit erhält so Informationen über die genaue Art der eingelagerten Ware. So können einzelne Fächer 12 bzw. Kartons 10 auch individuellen Kunden zugeordnet werden.

Einsatzmöglichkeiten umfassen beispielsweise die Medizintechnik. Auf Grund der neuen Medizintechnikrichtlinie müssen alle Medizinprodukte einen UDI aufweisen, welcher auf die Verpackung gedruckt wird. Dieser Code beinhaltet den Hersteller, Herstelldatum sowie Chargen- und Ablaufdatum. Wird nun das erfindungsgemäße System zur Bestellabwicklung genutzt, so kann der Hersteller bei Rückholaktionen genau den Standort der Ware sowie Informationen dazu ermitteln, ob die Ware bereits im Einsatz ist oder noch im Lager liegt (Traceability).

Eine weitere Einsatzmöglichkeit liegt im Einzelhandel. Dem Einzelhandel wird die Nachbeschaffung von Vorratswaren durch das erfindungsgemäße System erleichtert. Durch eine gegebenenfalls automatische Nachbeschaffung durch den Einzelhändler, kann dem Kunden immer ein volles Lager zur Verfügung gestellt werden. Die Ware könnte erst bei Entnahme durch den Kunden berechnet werden.

Eine weitere Einsatzmöglichkeit besteht in Apotheken. Durch Anwendung des erfindungsgemäßen Systems in pharmazeutischen Lagern wird dem Lagerhalter ermöglicht, aktuell die Verfügbarkeit sowie die zuvor erfassten Verfallsdaten der Medikamente zu prüfen, sofern die Waren beim Einlagern gescannt und deren Verfallsdaten erfasst werden.

Bei dem erfindungsgemäßen Behältnis kann es sich auch um eine mobile Lagerbox für Handwerker handeln. Wird das Behältnis in einem Firmenwagen beispielsweise eines Monteurs installiert, kann täglich der Verbrauch an Verbrauchsmaterialien aus der Box erfasst werden. Kommt der Firmenwagen nach Dienstende zurück, so kann die verbrauchte Ware wieder befüllt werden.

Weiterhin kann es sich bei dem erfindungsgemäßen Behältnis um einen Bestandteil eines Möbels handeln, wobei die als Sensorflächen dienenden Leiterbahnen direkt auf Möbelteile gedruckt werden können. Dadurch können Möbel für eine Lagerbewirtschaftung verwendet werden.

## Patentansprüche

1. Behältnis (10) für ein Warenwirtschaftssystem, das zur Aufnahme von Waren ausgebildet ist,
wobei es sich bei dem Behältnis (10) um einen Karton (10), eine Kunststoffbox (10) oder ein Holzbehältnis (10) handelt;
wobei das Behältnis (10) eine kapazitive Sensoreinrichtung (20) zur Erfassung des Vorhandenseins und/oder der Füllmenge von Waren aufweist, die eine Leiterbahn (22) umfasst, die durch den Aufdruck elektrisch leitender Tinte auf einer Oberfläche wenigstens einer Begrenzungswand des Behältnisses (10) gebildet ist; und
wobei die kapazitive Sensoreinrichtung (20) zwei Leiterbahnen (22) umfasst, die an der Begrenzungswand des Behältnisses (10) aufgedruckt sind, wobei eine der Leiterbahnen (22) als Messelektrode und die andere der Leiterbahnen (22) als Schirmelektrode dient, um Vorhandensein und/oder der Füllmenge von Waren in mehreren Bereichen oder Kompartimenten des Behältnisses (10) gesondert kapazitiv erfassen zu können, wobei die Leiterbahnen direkt auf die Begrenzungswand aufgedruckt sind.

2. Behältnis (10) nach Anspruch 1, **dadurch gekennzeichnet, dass** die Sensoreinheit (20) ausgebildet ist, periodisch kapazitive Bestandsabfragen durchzuführen.

3. Behältnis (10) nach einem der vorhergehenden Ansprüche, **dadurch gekennzeichnet, dass** die Sensoreinheit (20) eine Kommunikationsschnittstelle zur Übermittlung des Sensorsignals an eine Lagerverwaltungseinheit des Warenwirtschaftssystems und/oder eine Auswerteeinheit zur Digitalisierung des Sensorsignals aufweist.

4. Behältnis (10) nach einem der vorhergehenden Ansprüche, **dadurch gekennzeichnet, dass** das Behältnis (10) zusätzlich zu der kapazitiven Sensoreinrichtung (20) noch eine separate, eigenschaftsbestimmende Sensoreinrichtung umfasst, die geeignet ist, eine qualitative Eigenschaft einer vorhandenen Ware zu bestimmen.

5. Behältnis (10) nach Anspruch 4, **dadurch gekennzeichnet, dass** die eigenschaftsbestimmende Sensoreinrichtung ein IR-Spektrometer, ein RFID-Lesegerät, eine Kamera nebst Bildauswertungselektronik oder eine elektromagnetische Sensorik umfasst, vorzugsweise ein IR-Spektrometer.

6. Warenwirtschaftssystem mit einem oder mehreren Behältnissen (10) nach einem der vorhergehenden Ansprüche.

## Claims

1. Container (10) for a merchandise management system, which is configured to receive goods,
wherein the container (10) is a cardboard box (10), a plastic box (10) or a wooden container (10);
wherein the container (10) comprises a capacitive sensor device (20) for detecting the presence and/or the fill level of goods, which comprises a conductor track (22) that is formed by the printing of electrically conductive ink on a surface of at least one boundary wall of the container (10); and
wherein the capacitive sensor device (20) comprises two conductor tracks (22) which are printed on the boundary wall of the container (10), wherein one of the conductor tracks (22) serves as a measuring electrode and the other of the conductor tracks (22) serves as a shield electrode, in order to be able to separately capacitively detect the presence and/or the fill level of goods in a plurality of areas or compartments of the container (10), wherein the conductor tracks are printed directly on the boundary wall.

2. Container (10) according to claim 1, **characterized in that** the sensor unit (20) is configured to periodically perform capacitive inventory queries.

3. Container (10) according to one of the preceding claims, **characterized in that** the sensor unit (20) comprises a communication interface for transmitting the sensor signal to a warehouse management unit of the merchandise management system and/or an evaluation unit for digitizing the sensor signal.

4. Container (10) according to one of the preceding claims, **characterized in that** the container (10), in addition to the capacitive sensor device (20), further comprises a separate, property-determining sensor device which is suitable to determine a qualitative property of a present good.

5. Container (10) according to claim 4, **characterized in that** the property-determining sensor device comprises an IR spectrometer, an RFID reader, a camera together with image evaluation electronics, or an electromagnetic sensor system, preferably an IR spectrometer.

6. Merchandise management system with one or more containers (10) according to one of the preceding claims.

## Revendications

1. Contenant (10) pour un système de gestion de marchandises, qui est configuré pour recevoir des marchandises,
le contenant (10) étant un carton (10), une boîte en plastique (10) ou un contenant en bois (10) ;
le contenant (10) présentant un dispositif de détection capacitif (20) pour la détection de la présence et/ou du niveau de remplissage de marchandises, qui comprend une piste conductrice (22) qui est formée par l'impression d'encre électriquement conductrice sur une surface d'au moins une paroi de délimitation du contenant (10) ; et
le dispositif de détection capacitif (20) comprenant deux pistes conductrices (22) qui sont imprimées sur la paroi de délimitation du contenant (10), l'une des pistes conductrices (22) servant d'électrode de mesure et l'autre des pistes conductrices (22) servant d'électrode de blindage, afin de pouvoir détecter séparément par capacité la présence et/ou le niveau de remplissage de marchandises dans plusieurs zones ou compartiments du contenant (10), les pistes conductrices étant imprimées directement sur la paroi de délimitation.

2. Contenant (10) selon la revendication 1, **caractérisé en ce que** l'unité de détection (20) est configurée pour effectuer périodiquement des interrogations d'inventaire capacitives.

3. Contenant (10) selon l'une des revendications précédentes, **caractérisé en ce que** l'unité de détection (20) présente une interface de communication pour la transmission du signal de capteur à une unité de gestion d'entrepôt du système de gestion de marchandises et/ou une unité d'évaluation pour la numérisation du signal de capteur.

4. Contenant (10) selon l'une des revendications précédentes, **caractérisé en ce que** le contenant (10), en plus du dispositif de détection capacitif (20), comprend en outre un dispositif de détection séparé, déterminant les propriétés, qui est apte à déterminer une propriété qualitative d'une marchandise présente.

5. Contenant (10) selon la revendication 4, **caractérisé en ce que** le dispositif de détection déterminant les propriétés comprend un spectromètre IR, un lecteur RFID, une caméra avec une électronique d'évaluation d'image, ou un système de capteurs électromagnétiques, de préférence un spectromètre IR.

6. Système de gestion de marchandises avec un ou plusieurs contenants (10) selon l'une des revendications précédentes.
